# EUROPEAN PATENT APPLICATION

(11) **EP 2 395 309 A1**
(43) Date of publication of application: **14.12.2011**
(21) Application number: 10165306.1
(22) Date of filing: 08.06.2010
(51) Int. Cl.: F28D 15/04, C22C 23/06, H01L 23/427

(54) **Heat pipe**

(71) Applicant: Thermal Corp., Wilmington DE 19803 (US)
(72) Inventor: Yang, Xiao, Gateshead Tyne & Wear NE8 2ED (GB)
(74) Representative: Vinsome, Rex Martin

(57) **Abstract**

A heat pipe (2) comprising a body (4) containing a working fluid is disclosed. The working fluid is adapted to evaporate as a result of heating of a first part of the body and to condense as a result of cooling of a second part of the body. The container comprises a grooved wick structure (6), adapted to transport the working fluid in liquid state from the second part towards the first part; and a vapour channel (8) adapted to allow the working fluid to move in vapour state from the first location towards the second location. The wick structure is formed from at least one material containing at least one alloy including magnesium, 1% to 2.5% by weight manganese, and up to 2.5% by weight zinc.

## Description

The present invention relates to heat pipes, and relates particularly, but not exclusively, to light weight heat pipes for use in aerospace applications.

Heat pipes are used to rapidly transfer heat from a first location, for example adjacent to heat generating electronic components in a confined environment such as in the aerospace industry where space restrictions make effective heat dissipation difficult, to a second location, spaced from the first location, where the heat can be more effectively dissipated. A heat pipe generally consists of a sealed vessel of thermally conductive material lined with a wick structure wherein the vessel defines a vapour channel in communication with the wick structure. The vessel is evacuated and filled with working fluid at reduced pressure and then sealed, so that the internal pressure in the vessel is set by the vapour pressure of the working fluid. The heat pipe is arranged so that one part is at the first, high temperature location, and another part of the heat pipe is at the second, low temperature location. The application of heat to the first part of the heat pipe causes the working fluid to vaporise, drawing latent heat of vaporisation from the first location into the fluid. The high temperature vapour then flows rapidly along the vapour channel to the cooler second part of the heat pipe, where it condenses on the pipe walls and the latent heat of vaporisation is released at the second location and dissipated. The wick structure then transports the condensed working fluid back to the first location by means of capillary action.

Heat pipes are found to be extremely effective in improving heat dissipation in confined environments such as aerospace applications. However, because of the significant cost involved in transporting components in certain aerospace applications, such as placing satellites in orbit, there is significant pressure to reduce the weight of components.

Heat pipes formed from aluminium alloys, with ammonia used as the working fluid, are known.

US 2004/0134643 discloses an attempt to reduce the weight of a heat pipe, in which a light weight heat pipe vessel is formed from magnesium, lined with a protective layer of oxide or nitride, depending on the choice of working fluid. For example, a stable nitride is used as the protective layer if ammonia is used as the working fluid, and a stable oxide is used as the protective layer if water is used as the working fluid.

This arrangement provides the advantage of enabling the weight to be reduced significantly, since magnesium has a density of 1738kg/m³, i.e. about half the density of aluminium, but has similar thermal and mechanical properties. However, this arrangement suffers from the drawback that corrosion of magnesium often occurs when it comes into contact with certain types of working fluid. It is believed that the following corrosion reactions of magnesium in an aquatic environment occur:

Mg→ Mg²⁺ +2e⁻;

2H₂O+2e⁻ →H₂+2OH⁻;

Mg²⁺ + 2OH⁻→ Mg(OH)₂

As a result, the overall corrosion reaction can be expressed as:

**Mg+2H₂O→ Mg(OH)₂ +H₂**

In the case of magnesium alloys, the corrosion process is more complex, since in an electrolytic environment, the presence of other metals in magnesium promotes galvanic attack and can increase the corrosion rate significantly. The introduction of metal impurities into the magnesium base metal can occur by means of many different processes, and it is very difficult to remove all of the impurities from the melt when producing pure magnesium. It has been found that the corrosion rate increases significantly when the tolerance limit of a specific impurity is exceeded. In some cases, some impurities are introduced intentionally to the magnesium melt during the alloying process to improve mechanical properties such as such strength of the alloy. However, even with high purity magnesium and or properly controlled magnesium alloys, impurities can still be unintentionally introduced to the final product during subsequent machining as a result of improper tool selection. Furthermore, the production of hydrogen gas during the corrosion process produces the disadvantage that because the hydrogen gas is non-condensable, it has a detrimental effect on heat pipe performance if formed inside the heat pipe.

In view of this, the protective layer must be made very robust in order to avoid any fractures through which the working fluid can leak into contact with the magnesium. This significantly increases the complexity, and therefore the cost of manufacture, of the heat pipe, and some customers may nonetheless be reluctant to use the heat pipe in aerospace applications because of the potentially serious consequences of contact between the magnesium and the working fluid.

Preferred embodiments of the present invention seek to overcome one or more of the above disadvantages of the prior art.

According to the present invention, there is provided a heat pipe comprising a container adapted to have at least one working fluid sealed therein, wherein at least one said working fluid is adapted to evaporate as a result of heating of at least one first part of the container and to condense as a result of cooling of at least one second part of the container, the container comprising:
wick means adapted to transport at least one said working fluid in liquid state from at least one said second part towards at least one said first part; and
at least one vapour channel adapted to allow at least one said working fluid to move in vapour state from at least one said first location towards at least one said second location;
wherein said wick means is formed from at least one material containing at least one alloy including magnesium, 1% to 2.5% by weight manganese, and up to 2.5% by weight zinc.

The present invention is based on the surprising discovery that certain magnesium alloys are compatible with certain working fluids, for example ethanol, acetone and ammonia. This provides the advantage that no protective coating separating the magnesium from the working fluid is necessary, as a result of which the reliability of the heat pipe is improved, while its manufacture is simplified. This in turn significantly decreases the cost of manufacture of the heat pipe.

At least one said alloy may further include up to 0.2% by weight one or more metal impurities.

At least one said alloy may include up to 0.01% by weight iron.

At least one said alloy may include up to 0.005% by weight nickel and/or copper.

At least one said alloy may include 1.8% to 2.2% by weight zinc and 0.75% to 1.25% by weight manganese.

At least one said working fluid may include at least one alcohol and/or at least one ketone and/or ammonia.

At least one said working fluid may comprise ethanol and/or acetone.

At least one said working fluid may comprise ammonia.

A preferred embodiment of the invention will now be described, by way of example only and not in any limitative sense, with reference to the accompanying drawing, which shows a schematic partially cut away perspective view of a heat pipe embodying the present invention.

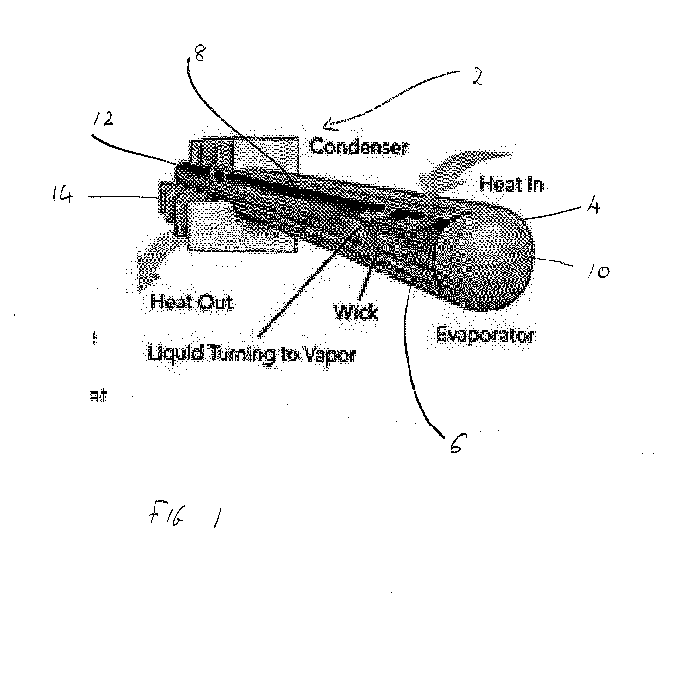

Referring to Figure 1, a heat pipe 2 comprises a sealed body 4 formed from a magnesium alloy such as ZM21 (i.e. approximately 2% by weight zinc, 1% by weight manganese and approximately 97% by weight magnesium) defining a grooved wick structure 6 surrounding a vapour transport channel 8 connecting an evaporator portion 10 of the heat pipe 2 to a condenser portion 12 of the heat pipe 2. The condenser portion 12 is surrounded by cooling fins 14 for effective heat dissipation. The body 4 is evacuated and a working fluid comprising ethanol, acetone, ethanol/acetone mixture or ammonia is sealed inside the body 4 such that the working fluid is at reduced pressure and wets the wick structure 6.

The body 4 is formed by first extruding a tube with a grooved structure which will subsequently form the wick structure 6. The grooves formed at each end of the tube are then machined away at each end to a depth of approximately 12mm. The extruded tube is then spun, and then the end is formed over using a number of small incremental movements. Once both ends are completely formed over, the tube should then be hermetically sealed, and a small hole is created at one end and this is used to introduce the working fluid. The hole is then pinned or closed and the tube heated, and the pin is subsequently momentarily removed to expel the non condensable gases and then replaced and welded in place

It has been found that the alloy ZM21 is compatible with certain working fluids such as acetone, ethanol, acetone/ethanol mixture or ammonia, as a result of which corrosion is avoided and no protective layer is required between the wick structure 6 and the working fluid. This therefore significantly improves the ease of manufacture and reliability of the heat pipe 2. In the ZM21 alloy used to form the body 4 of the heat pipe 2, metal impurities such as iron, nickel, copper or cobalt are often present, up to a total amount of approximately 0.2 weight % of the total alloy. In particular, iron is often present at less than 0.01 weight %, and nickel and copper present at no more than 0.005 weight %.

The presence of manganese improves the stress corrosion resistance of the alloy and further enhances the anticorrosion and welding properties of the alloy. Furthermore, manganese reacts with iron ions and generates Fe2Mn during the magnesium alloy formation process, which can be removed as slag and minimise contamination by iron. If excessive manganese is introduced into the magnesium alloy, the plasticity of the alloy is reduced. For example, if the manganese increases from 0.4 weight % to 2.5 weight %, the elongation ratio of the alloy decreases from 5 % to 3 %.

The presence of zinc makes the magnesium alloy electrochemically less reactive, thereby minimising the corrosion rate. However, the presence of more than 2.5 weight % of zinc can have a detrimental effect on the anticorrosion behaviour of the magnesium alloy. The presence of the zinc assists in overcoming the harmful corrosive effect of iron and nickel impurities that may be present in the magnesium alloy.

The following alloys are found to be compatible with the working fluids ethanol, acetone, ethanol/acetone mixture, and ammonia, and the ZM21 alloy can be extruded from unscalped billets at speeds up to four times faster than for comparable magnesium alloys.

| **Main element** | **Zn** | **Mn** | **Mg** |
|---|---|---|---|
| Standard ZM21 [5, 18,19] | 2.00 wt% | 1.00 wt% | rest |
| ZM21 alloy 1 [20] | 2.10 wt% | 0.90 wt% | rest |
| ZM21 alloy 2 [17] | 2.10 wt% | 1.11 wt% | rest |
| ZM21 alloy 3 [21] | 2.20 wt% | 0.80 wt% | rest |
| ZM21 alloy 3 [22] | 2.10 wt% | 0.75 wt% | rest |

The operation of the heat pipe of Figure 1 will now be described. The evaporator portion 10 of the heat pipe 2 is located in a region where heat is generated but is difficult to dissipate, such as adjacent to electronics in an aerospace application. The condenser portion 12 is located in a region spaced from the evaporator portion 10 and is surrounded by cooling fins 14 such that heat can be significantly more effectively dissipated in the vicinity of the condenser portion 12 than at the evaporator portion 10. The application of heat to the evaporator portion 10 causes evaporation of the working fluid which draws significant amounts of heat from the evaporator portion 10 in the form of the latent heat of evaporation of the working fluid. The working fluid then travels along the vapour transport channel 8 to the condenser portion 12 where it condenses, and the latent heat of evaporation is released and dissipated by the cooling fins 14. The wick structure 6 is wet by the working fluid condensing at the condenser portion 12, and then transports the working fluid back to the evaporator portion 10 as a result of capillary action. As a result, the process continues as long as the temperature difference between the evaporator portion 10 and condenser portion 12 is maintained.

### Example

Tests of various working fluids with the ZM21 alloy were carried out. Thermal tests started from room temperature (20°C) to the 8K superheat temperature of each working fluid. The thermal test was carried out under a pressure of 5bar for ammonia and at atmospheric pressure for the other working fluids. The following conclusions were drawn after more than 100 hours of thermal testing.
1. All of the working fluids gave good thermal performance.
2. Water and methanol are not compatible with ZM21.
3. Acetone, ethanol, acetone/ethanol mixture and ammonia are compatible with ZM21.
4. Using acetone and ethanol as working fluids, an operating temperature range from -40°C to 140°C is provided.
5. Using ammonia as a working fluid, the operating temperature ranges from -60°C to 120°C.

Compatibility tests carried out over 24 months indicate the following:
1. Copper and iron contaminate the ZM21 surface significantly.
2. At room temperature, there is no corrosion on the ZM21 surface if small samples are placed in pure acetone, pure ethanol and an acetone/ethanol mixture.
3. Water/ZM21, methanol/ZM21 compatibility life tests fail. In the case of the water/ZM21 tests, Mg(OH)2 was generated along the ZM21 surface and gaseous hydrogen was also generated. In the case of pure methanol, a vigorously exothermic reaction occurred in the test jar, and the ZM21 surface became black.

It will be appreciated by persons skilled in the art that the above embodiment has been described by way of example only, and not in any limitative sense, and that various alterations and modifications are possible without departure from the scope of the invention as defined by the appended claims.

## Claims

1. A heat pipe comprising a container adapted to have at least one working fluid sealed therein, wherein at least one said working fluid is adapted to evaporate as a result of heating of at least one first part of the container and to condense as a result of cooling of at least one second part of the container, the container comprising:
wick means adapted to transport at least one said working fluid in liquid state from at least one said second part towards at least one said first part; and
at least one vapour channel adapted to allow at least one said working fluid to move in vapour state from at least one said first location towards at least one said second location;
wherein said wick means is formed from at least one material containing at least one alloy including magnesium, 1% to 2.5% by weight manganese, and up to 2.5% by weight zinc.

2. A heat pipe according to claim 1, wherein at least one said alloy further includes up to 0.2% by weight one or more metal impurities.

3. A heat pipe according to claim 2, wherein at least one said alloy includes up to 0.01% by weight iron.

4. A heat pipe according to claim 2 or 3, wherein at least one said alloy includes up to 0.005% by weight nickel and/or copper.

5. A heat pipe according to any one of the preceding claims, wherein at least one said alloy includes 1.8% to 2.2% by weight zinc and 0.75% to 1.25% by weight manganese.

6. A heat pipe according to any one of the preceding claims, wherein at least one said working fluid includes at least one alcohol and/or at least one ketone and/or ammonia.

7. A heat pipe according to claim 6, wherein at least one said working fluid comprises ethanol and/or acetone.

8. A heat pipe according to claim 6, wherein at least one said working fluid comprises ammonia.
